# EUROPEAN PATENT APPLICATION

(11) **EP 1 117 007 A2**
(43) Date of publication of application: **18.07.2001**
(21) Application number: 00126477.9
(22) Date of filing: 07.12.2000
(51) Int. Cl.: G03F 7/30

(54) **Development processing apparatus and developing method for photosensitive material**

(30) Priority: 08.12.1999 JP 34890799; 13.12.1999 JP 35325499; 21.02.2000 JP 2000043135
(71) Applicant: FUJI PHOTO FILM CO., LTD., Kanagawa 250-01 (JP)
(72) Inventor: Furukawa, Koji, Yoshida-cho, Haibara-gun, Shizuoka (JP); Ohishi, Chikashi, Yoshida-cho, Haibara-gun, Shizuoka (JP)
(74) Representative: HOFFMANN - EITLE

(57) **Abstract**

A development processing apparatus comprising: a developing bath for developing an exposed photosensitive material having a photosensitive resin composition with a development processing solution; an intermediate waste solution tank to which an overflown waste solution from the developing bath is introduced; an electrolytic cell which electrolyzes a developing working solution introduced from the developing bath and the overflown waste solution introduced from the intermediate waste solution tank, the electrolytic cell comprising a negative electrode chamber having a negative electrode, a positive electrode chamber having a positive electrode and a bulkhead to divide the negative electrode chamber and the positive electrode chamber; and a circulating mechanism comprising a first route for circulating the developing working solution between the negative electrode chamber of the electrolytic cell and the developing bath, and a second route for circulating the overflown waste solution between the positive electrode chamber of the electrolytic cell and the intermediate waste solution tank.

## Description

### FIELD OF THE INVENTION

The present invention relates to a development apparatus and a developing method for processing a photosensitive material. Specifically, the invention relates to a development apparatus and a developing method for processing a photosensitive resin composition carried on a substrate for use in the manufacture of a lithographic printing plate, a printed wiring substrate or an integrated circuit. More specifically, the present invention relates to a development processing apparatus and a developing method each capable of automatically and stably processing a material having a plurality of photosensitive resin compositions. Particularly, the present invention relates to a development processing apparatus and a developing method each capable of stably performing development processing in the production of a lithographic printing plate precursor such as a PS plate.

### BACKGROUND OF THE INVENTION

The process of producing a lithographic printing plate from a printing plate precursor carrying a photosensitive resin composition (hereinafter referred to as "PS plate") includes a process of developing a PS plate, and the apparatus for the development has already been put to practical use. Since the development is effected by eluting the non-image area of a photosensitive resin composition after image exposure into an alkaline development processing solution, the alkali agent component of the alkaline development processing solution in a developing tank is consumed and the activity is reduced. Further, even if the development of the material having a photosensitive resin composition is not performed, the surface of the development processing solution is always exposed to air, therefore, the development processing solution absorbs the carbon dioxide in the air, the alkali agent component is consumed and the activity is similarly reduced. That is, the processing fatigue resulting from the development processing of the photosensitive resin composition and the aging fatigue (or aging degradation) caused by the contact of the development processing solution with air progress at the same time in a development processing apparatus even if there is difference in degree. When the degradation progresses more than a definite degree, proper development processing cannot be performed. It is well known, therefore, to replenish a developing replenisher opportunely to recover from the degradation.

For preventing the reduction of the degree of activity of a development processing solution, a method of replenishing a replenisher generally containing an alkali agent and a buffer in higher concentration than the development processing solution to compensate for the consumed amount of alkali is adopted. This replenishing method is necessary for stably development processing a large quantity of photosensitive resin composition with a development processing apparatus but also has the following problems.
(1) An overflow of a developing solution is discharged from a developing bath as a developing waste solution with the replenishment, but since a waste solution cannot be drained to sewerage, it is necessary to devise a proper measure of the discard of a waste solution. The discard of a waste solution requires an investment and the discard itself influences the environment.
(2) In addition to the above item (1), performing replenishment means to discharge the excess amount of the component of a development processing solution such as an alkali agent, which causes an economical load.
(3) When the photosensitive resin composition eluted into a development processing solution having high salt concentration is precipitated and the precipitate adheres to a transporting system such as rollers, etc., anything unusual may occur in transporting in the development processing apparatus or the development processing apparatus may stop. The development processing apparatus must be stopped to remove the precipitate by washing, which lowers the productivity and takes time of work.
(4) Since the chemicals added as an alkali agent or a buffer (silicate, phosphate, etc.) increase the salt concentration of a development processing solution, the component of the photosensitive resin composition eluted into the development processing solution is liable to be precipitated on a transporting system or a developing tank (especially silicate).

As the countermeasure of the above problems (1) and (2), adding only the necessary component to the replenisher to reduce the loss due to overflow is considered. As the method of adding only the necessary component, a method of directly adding the consumed component to the development processing solution under use is considered, but the dissolution of the development processing solution takes time, which may cause troubles and, at the same time, this method results in the aggravation of the points of the problems with respect to the above (3) and (4), hence this does not substantially solve the problem of replenishing, although problems (1) and (2) are somewhat improved.

On the other hand, as is well known, it is possible to cause electrolysis of water by immersing an inactive electrode in an aqueous solution of a neutral salt to thereby generate a hydrogen ion at the positive electrode and a hydroxide ion at the negative electrode. This method is thought to be better as the countermeasure of the above problems (1) and (2), since electrolysis of water does not increase the concentration of salt. In fact, it is known to utilize a hydroxide ion generated at the negative electrode for increasing the pH value of a development processing solution of a silver halide photographic material.

However, means of supplying an alkali agent by electrolysis has not been used in the development of a material having photosensitive resin composition such as a photosensitive material for printing generally utilizing a photolysis reaction of quinonediazide or diazo coupling of a diazonium salt. The reason is that, although called a development processing solution, the development processing solution of a material having a photosensitive resin composition is fundamentally different from the development processing solution of a silver halide photographic material in composition, and the organic high polymer component water-solubilized and eluted from a photosensitive resin composition and the siloxane series resin component dissolved out of an aluminum support are contained in the development processing solution of a material having a photosensitive resin composition,. therefore, it can be easily presumed that the poisoning of the electrode, i.e., so-called organic pollution, is caused and the electrolytic operation is difficult to be maintained stably.

In addition, an image-forming method comprising forming a dye by a diazo coupling reaction using a hydroxide ion formed by electrolysis is disclosed in U.S. Patent 2,541,488. However, this is different from a development processing solution and does not contain organic and inorganic resin compositions. Furthermore, this method has been realized by a newly prepared and not poisoning reaction system and this system is different from the photosensitive resin composition of the present invention containing various high polymer components.

Another drawback with respect to the development of a material having a photosensitive resin composition accompanied by replenishment is that sufficiently accurate replenishment is difficult to be maintained with ordinary control of replenishment by a pH value. In the practicable region of a development processing solution for a material having a photosensitive resin composition, it is contrived to maintain a salt concentration low and a pH value high for accelerating the elution of unnecessary composition components. Accordingly, even slight generation of a hydroxide ion or a hydrogen ion in a development processing solution influences the performance of a development processing solution. Notwithstanding, as the pH value of a development processing solution is high, the behavior of the pH value to the variation of the concentration of an alkali component is dull. Therefore, it is necessary to make the allowable width of the control value of the pH narrow and it has so far been contrived to maintain stable development performance by controlling the variation of a pH value by a large quantity of replenishment. Further, a high replenishment rate contributes to the prevention of the precipitation of the eluted photosensitive resin composition component. That is, the prevention of the fatigue of a development processing solution and the prevention of the formation of precipitates are not compatible with the reduction of a developing replenisher and a waste solution, and it has been strongly desired to satisfy both problems but the situation still remains unsolved.

### SUMMARY OF THE INVENTION

An object of the present invention is to provide a development processing apparatus and a developing method each capable of solving the above problems to reduce the amounts of a developing replenisher, replenishing agents and a developing waste solution, and constantly obtaining stable development quality when development of a photosensitive material is performed steadily or intermittently with maintaining the performance of the development processing solution in a developing bath by replenishment.

More Specifically, an object of the present invention is to provide a development apparatus and a developing method for processing a lithographic printing plate having a photosensitive resin composition, by which a dissolved component does not precipitate with a reduced replenishing rate, the discharge amount of a waste solution can be controlled, and development quality is not impaired and can be maintained stably.

Other objects and effects of the present invention will become apparent from the following description.

The above-described objects of the present invention have been achieved by providing the following development processing apparatuses and developing methods.
I) In a first aspect, the present invention relates to a development processing apparatus comprising:
   a developing bath for developing an exposed photosensitive material having a photosensitive resin composition with a development processing solution;
   an intermediate waste solution tank to which an overflown waste solution from said developing bath is introduced;
   an electrolytic cell which electrolyzes a developing working solution introduced from said developing bath and said overflown waste solution introduced from said intermediate waste solution tank, said electrolytic cell comprising a negative electrode chamber having a negative electrode, a positive electrode chamber having a positive electrode and a bulkhead to divide said negative electrode chamber and said positive electrode chamber; and
   a circulating mechanism comprising a first route for circulating said developing working solution between the negative electrode chamber of said electrolytic cell and the developing bath, and a second route for circulating said overflown waste solution between the positive electrode chamber of said electrolytic cell and the intermediate waste solution tank.
II) In a second aspect, the present invention relates to the following development processing apparatuses (2-1) and (2-2).
   (2-1) A development processing apparatus comprising:
      a developing bath for developing an exposed photosensitive material with a development processing solution;
      a replenishing member which replenishes a developing replenisher to said developing bath according to at least one of: a cumulative processing area of said photosensitive material; a cumulative operating time of said development processing apparatus; and a cumulative stopping time of said development processing apparatus;
      a detector which detects a development activity of the development processing solution in said developing bath;
      an electrolytic cell which electrolyzes a developing working solution introduced from said developing bath, said electrolytic cell comprising a negative electrode chamber having a negative electrode, a positive electrode chamber having a positive electrode and a bulkhead to divide said negative electrode chamber and said positive electrode chamber;
      a circulating mechanism for circulating said developing working solution between the negative electrode chamber of said electrolytic cell and the developing bath; and
      a controller which is connected to said electrolytic cell so as to control application of an electric current to said positive and negative electrodes according to the development activity of the development processing solution detected by said detector.
   (2-2) A development processing apparatus comprising:
      a developing bath for developing an exposed photosensitive material with a development processing solution;
      a replenishing member which replenishes a developing replenisher to said developing bath;
      a detector which detects a development activity of the development processing solution in said developing bath;
      an electrolytic cell which electrolyzes a developing working solution introduced from said developing bath, said electrolytic cell comprising a negative electrode chamber having a negative electrode, a positive electrode chamber having a positive electrode and a bulkhead to divide said negative electrode chamber and said positive electrode chamber;
      a circulating mechanism for circulating said developing working solution between the negative electrode chamber of said electrolytic cell and the developing bath;
      a first controller which is connected to said electrolytic cell so as to control application of an electric current to said positive and negative electrodes according to at least one of: a cumulative processing area of said photosensitive material; a cumulative operating time of said development processing apparatus; and a cumulative stopping time of said development processing apparatus; and
      a second controller which is connected to said replenishing member so as to control the replenishment to said developing bath according to the development activity of the development processing solution detected by said detector.
III) In a third aspect, the present invention relates to the following developing methods (3-1) and (3-2).
   (3-1) A method for developing an exposed photosensitive material using a development processing apparatus comprising: a developing bath and an electrolytic cell comprising a negative electrode chamber and a positive electrode chamber, which developing method comprising:
      maintaining a development activity of a developing solution,
      wherein said maintaining of the development activity of the developing solution is carried out by electrolytic treatment of the developing solution in the negative electrode chamber of said electrolytic cell, and by replenishing a developing replenisher to the developing solution in said developing bath,
      said electrolytic treatment being performed according to a development activity of the developing solution detected in said developing bath,
      said replenishment of the developing replenisher being performed by corresponding to a processing area of said photosensitive material and an operating time of said development processing apparatus, wherein said correspondence is controlled according to a physical property of a developing waste solution introduced into the positive electrode chamber of said electrolytic cell.
   (3-2) A method for developing an exposed photosensitive material using a development processing apparatus comprising: a developing bath and an electrolytic cell comprising a negative electrode chamber and a positive electrode chamber, which developing method comprising:
      maintaining a development activity of a developing solution,
      wherein said maintaining of the development activity of the developing solution is carried out by electrolytic treatment of the developing solution in the negative electrode chamber of said electrolytic cell, and by replenishing a developing replenisher to the developing solution in said developing bath,
      said replenishment of the developing replenisher being performed according to a development activity of the developing solution detected in said developing bath,
      said electrolytic treatment being performed by corresponding to a processing area of said photosensitive material and an operating time of said development processing apparatus, wherein said correspondence is controlled according to a physical property of a developing waste solution introduced into the positive electrode chamber of said electrolytic cell.

### BRIEF DESCRIPTION OF THE ACCOMPANYING DRAWINGS

Fig. 1 is a block diagram showing Embodiment 1-1 of the present invention.

Fig. 2 is a diagram showing an example of electrolytic cell according to the present invention.

Fig. 3 is a block diagram showing Embodiment 1-2 of the present invention.

Fig. 4 is a block diagram showing Embodiment 1-3 of the present invention.

Fig. 5 is a block diagram showing Embodiment 1-4 of the present invention.

Fig. 6 is a block diagram showing Embodiment 2-1 of the present invention.

Fig. 7 is a block diagram showing Embodiment 2-2 of the present invention.

Fig. 8 is a block diagram of an apparatus for carrying out the developing method of the present invention.

Fig. 9 is a block diagram of another apparatus for carrying out the developing method of the present invention.

### DETAILED DESCRIPTION OF THE INVENTION

According to the development processing apparatus of the first aspect of the present invention, the developing performance of a developing working solution can be recovered by electrolyzing a developing working solution whose alkali component has been consumed and an overflown intermediate waste solution and they can be reused in development. An overflown intermediate waste solution is in the first place introduced into an intermediate waste solution tank and then to an electrolytic cell. The intermediate waste solution introduced into the electrolytic cell passes through the positive electrode side in the electrolytic cell and introduced into the intermediate waste solution tank again. At the same time, the developing working solution from the developing bath is introduced into the negative electrode side in the electrolytic cell and the introduced developing working solution is returned to the developing bath. That is, the intermediate waste solution introduced into the intermediate waste solution tank is circulating between the intermediate waste solution tank and the positive electrode side of the electrolytic cell and the developing working solution is circulating between the developing bath and the negative electrode side of the electrolytic cell.

According to the first aspect of the present invention, the developing working solution and the intermediate waste solution are electrolyzed in the electrolytic cell. As the developing working solution comes into contact with the negative electrode, the concentration of the alkali component (i.e., a hydroxide ion) increases by the electrolysis and the developing performance is recovered. The bubbles generated by the electrolysis in the electrolytic cell are flown by the above circulation to prevent the photosensitive layer component in the solution from electrodepositing and precipitating on the electrodes and the interelectrode resistance from increasing. As a result, good electrolysis can be continued. Accordingly, good recovery of the developing performance of the developing working solution can be continued.

According to the development processing apparatus as described in the above item (2-1) in the second aspect of the present invention, a developing replenisher is replenished to a developing bath and at the same time a developing working solution whose alkali component has been consumed is electrolyzed, thus the developing performance of the developing working solution can be recovered and the developing working solution can be reused in development. The developing working solution from the developing bath is introduced into the negative electrode side in the electrolytic cell and the introduced developing working solution is returned to the developing bath. That is, the developing working solution is circulating between the developing bath and the negative electrode side of the electrolytic cell.

Further, in the development processing apparatus as described in the above item (2-1), when the controller judges that the developing performance of the development processing solution is lowered with the development activity detected by the detector as the criterion, an electric current is applied to the positive electrode and the negative electrode. Thus, the developing working solution and the developing waste solution are electrolyzed in the above-described electrolytic cell. As the developing working solution comes into contact with the negative electrode by the electrolysis, the concentration of the alkali component (i.e., a hydroxide ion) increases by the electrolysis and the developing performance is recovered.

Further, in the development processing apparatus as described in the above item (2-1), a developing replenisher is replenished to the developing bath by the replenishing member and the developing performance of a developing working solution is recovered. In this case, it is preferred that the above-described replenishing member is connected to the controller to periodically control the replenishment according to at least one of the cumulative processing area of the material having a photosensitive resin composition, the cumulative operating time of the development processing apparatus, and the cumulative stopping time of the development processing apparatus, and replenishment is performed according to the instruction from the controller.

In the development processing apparatus of the above item (2-2) in the second aspect of the present invention, when the controller judges that the developing performance of the development processing solution is lowered with the development activity detected by the detector as the criterion, a developing replenisher is replenished to the developing bath, thus the developing performance of the development processing solution is recovered.

Further, in the development processing apparatus as described in the above item (2-2), the electrolytic cell is connected to the controller to periodically control the application of an electric current to the positive electrode and the negative electrode according to at least one of the cumulative processing area of the material having a photosensitive resin composition, the cumulative operating time of the development processing apparatus, and the cumulative stopping time of the development processing apparatus, and an electric current is applied to the positive electrode and the negative electrode according to the instruction from the controller. As the developing working solution is hydrolyzed in the electrolytic cell and comes into contact with the negative electrode, the concentration of the alkali component (i.e., a hydroxide ion) increases by the electrolysis and the developing performance is recovered.

Further, in the development processing apparatuses as described in the above items (2-1) and (2-2), the bubbles generated by the electrolysis in the electrolytic cell are flown by the above circulation to prevent the photosensitive layer component in the solution from electrodepositing on the electrodes and the interelectrode resistance from increasing. As a result, good electrolysis can be continued without consuming extra electric power. Accordingly, good recovery of the developing performance of the developing working solution can be continued.

Further, the development processing apparatuses as described in the above items (2-1) and (2-2) may be equipped with circulating mechanism comprising introducing the overflown waste solution from the developing bath into a tank (called an intermediate waste solution tank), introducing the waste solution in the intermediate waste solution tank (called an intermediate waste solution) into the positive electrode side of the electrolytic cell, and introducing the intermediate waste solution into the intermediate waste solution tank again. The positive electrode side of the electrolytic cell may be equipped with a electrolysis reservoir for reserving a solution to be electrolyzed, by which the time required in solution exchange when the electrolytic cell is provided can be saved and, further, similarly to the above-described circulation of the development processing solution, the photosensitive layer component in the solution can be prevented from electrodepositing and precipitating on the electrodes and the increase of interelectrode resistance can be prevented. As a result, good electrolysis can be continued without consuming extra electric power.

Further, in the development processing apparatuses as described in the above items (2-1) and (2-2), it is preferred that the detector detects at least one of the electric conductivity of the development processing solution, the pH value of the development processing solution, and the specific gravity and the opacity of the development processing solution, as the development activity of the development processing solution.

Further, in the development processing apparatuses as described in the above items (2-1) and (2-2), it is preferred that the replenishing rate of a developing replenisher is smaller than the amount conventionally used. By reducing the amount of a replenisher, the amount of an overflown waste solution can be reduced, as a result, the amount of a waste solution can be reduced. Since the development processing apparatus according to the present invention contrives to recover the developing performance of the development processing solution also by electrolysis, the recovering function of the developing performance cannot be reduced even when the replenishing rate of a developing replenisher is reduced.

According to the developing method as described in the above item (3-1) in the third aspect of the present invention, a developing replenisher is replenished to a developing bath and at the same time a developing working solution whose alkali component has been consumed and a waste solution are electrolyzed according to the development activity of the developing working solution detected by the first sensor, thus the developing performance of the developing working solution can be recovered and the developing working solution can be reused in development. The waste solution from the developing bath is in the first place introduced into an intermediate waste solution tank (this solution is called an intermediate waste solution for convenience sake) and then into an electrolytic cell. The intermediate waste solution introduced into the electrolytic cell is again introduced into the intermediate waste solution tank through the positive electrode side in the electrolytic cell. At the same time, the developing working solution from the developing bath is introduced into the negative electrode side in the electrolytic cell and the introduced developing working solution is returned to the developing bath. That is, the intermediate waste solution introduced into the intermediate waste solution tank is circulating between the intermediate waste solution tank and the positive electrode side of the electrolytic cell and the developing working solution is circulating between the developing bath and the negative electrode side of the electrolytic cell.

Further, according to the developing method as described in the above item (3-1), the developing performance of the developing solution in the developing bath can be recovered by replenishing a developing replenisher to the developing bath according to at least one of the cumulative processing area of the photosensitive material, the cumulative operating time of the development processing apparatus, and the cumulative stopping time of the development processing apparatus.

Further, according to the developing method as described in the above item (3-1), the development activity of the intermediate waste solution overflown from the developing bath and introduced into the intermediate waste solution tank is detected by the second detector, and the replenishing rate of the developing replenisher to the developing bath is adjusted according to the detected development activity. The detected development activity is most preferably pH, but electric conductivity is detected first and pH may be estimated from the electric conductivity detected. At this time, when the detected and estimated pH value of the intermediate waste solution is more than the allowable ceiling value, it is preferred that the replenishing rate of the developing replenisher to the developing bath is reduced to reduce the amount of the overflown solution from the developing bath. While when the pH value is less than the allowable bottom value, it is preferred that the replenishing rate of the developing replenisher to the developing bath is increased to increase the amount of the overflown solution from the developing bath. If the amount of the solution overflown and introduced into the intermediate waste solution tank is decreased, the pH value in the intermediate waste solution tank gradually decreases by the circulation inclusive of electrolysis and becomes lower than the allowable ceiling value, in contrast with this, if the amount of the overflown solution is increased, the pH value in the intermediate waste solution tank gradually increases and becomes higher than the allowable bottom value.

In this case, it is preferred that the allowable ceiling value should be, for example, the boundary value (pH = 12.5 as of December, 1999) at which the intermediate waste solution comes under special control industrial waste. Since the pH value of the final waste solution almost equals to the pH value of the intermediate waste solution, the final waste solution can be discarded without coming under special control industrial waste by prescribing such allowable ceiling value.

Furthermore, the allowable bottom value is generally such that the photosensitive layer component dissolved into the waste solution is not precipitated or deposited, and the electrolysis in the above electrolytic cell can be performed well, preferably a pH value of 12.2. If the pH value of the intermediate waste solution decreases too much, hydroxide ions in the intermediate waste solution tank become insufficient and good electrolysis cannot be performed.

Further, according to the developing method as described in the above item (3-2) in the third aspect of the present invention, the developing performance in the developing bath can be recovered by replenishing a developing replenisher to the developing bath according to the development activity of the development processing solution detected by the first sensor. Further, when electrolysis is performed according to at least one of the cumulative processing area of the photosensitive material, the cumulative operating time of the development processing apparatus, and the cumulative stopping time of the development processing apparatus, the development activity of the intermediate waste solution in the intermediate waste solution tank is detected by the second detector, and the application amount of an electric current is controlled according to the detected value. When an electric current is applied to the electrolytic cell, electrolysis is performed in the electrolytic cell. Since the developing working solution is brought into contact with the negative electrode, the concentration of the alkali component (i.e., a hydroxide ion) increases by the electrolysis and the developing performance is recovered. Since the intermediate waste solution is brought into contact with the positive electrode, the alkali component decreases by the electrolysis. The preferred point of this electrolysis is capable of decreasing the pH value of intermediate waste solution while increasing the pH value of the developing working solution. According to this mechanism, the intermediate waste solution in the intermediate waste solution tank can be made harmless while recovering the developing performance of the developing working solution in the developing bath (i.e., the development processing solution). The final waste solution is a waste solution discharged from the intermediate waste solution tank, hence decreasing the pH value of the intermediate waste solution almost equals to decreasing the pH value of the final waste solution.

Further, according to the developing method as described in the above item (3-2), the development activity detected by the first sensor is most preferably pH, but electric conductivity is detected first and pH may be estimated from the electric conductivity detected. The developing working solution and the developing waste solution are electrolyzed in the electrolytic cell according to the detected and estimated pH value. When the detected and estimated pH value is more than the allowable ceiling value, it is preferred to increase the amount of an electric current to be applied to the positive electrode and the negative electrode. While when the pH value is less than the allowable bottom value, it is preferred to decrease the application amount of an electric current. In this case, it is preferred that the allowable ceiling value should be, for example, the boundary value (pH = 12.5 as of December, 1999) at which the intermediate waste solution comes under special control industrial waste. Since the pH value of the final waste solution almost equals to the pH value of the intermediate waste solution, the final waste solution can be discarded without coming under special control industrial waste by prescribing such allowable ceiling value.

Further, according to the developing methods as described in the above items (3-1) and (3-2), the bubbles generated by the electrolysis in the electrolytic cell are flown by the above circulation to prevent the photosensitive layer component in the solution from electrodepositing and precipitating on the electrodes and the interelectrode resistance from increasing. As a result, good electrolysis can be continued without consuming extra electric power. Accordingly, good recovery of the developing performance of the developing working solution can be continued.

Further, according to the developing methods as described in the above items (3-1) and (3-2), it is contrived to recover the developing performance of the development processing solution by electrolysis, accordingly, the replenishing rate of a developing replenisher can be reduced to a smaller amount than the amount conventionally used, and the amount of a waste solution can also be reduced.

The development processing solution for use in the development processing apparatus and developing method according to the present invention preferably has a pH value of from 9.0 to 14.0, preferably from 12.0 to 13.5. Conventionally well-known alkaline aqueous solutions can be used as a development processing solution for use in such development processing, e.g., inorganic alkali agents such as sodium silicate, potassium silicate, sodium tertiary phosphate, potassium tertiary phosphate, ammonium tertiary phosphate, sodium secondary phosphate, potassium secondary phosphate, ammonium secondary phosphate, sodium carbonate, potassium carbonate, ammonium carbonate, sodium hydrogencarbonate, potassium hydrogencarbonate, ammonium hydrogencarbonate, sodium borate, potassium borate, ammonium borate, sodium hydroxide, ammonium hydroxide, potassium hydroxide, and lithium hydroxide can be exemplified. Organic alkali agents, such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, and pyridine can also be used in the present invention. These alkali agents are used alone or in combination of two or more.

Of the above alkaline aqueous solutions, a development processing solution which exhibits a higher effect of the present invention is an aqueous solution containing alkali metal silicate and having a pH value of 12 or more. An aqueous solution of alkali metal silicate is capable of adjusting development property by the ratio of silicon oxide SiO₂, which is the component of silicate, to alkaline metallic oxide M₂O (generally represented by the molar ratio of SiO₂/M₂O) and the concentration. For example, an aqueous solution of sodium silicate having a molar ratio of SiO₂/Na₂O of from 1.0 to 1.5 (i.e., SiO₂/Na₂O is from 1.0 to 1.5) and an SiO₂ content of from 1 to 4 wt% as disclosed in JP-A-54-62004 (the term "JP-A" as used herein means an "unexamined published Japanese patent application"), and an aqueous solution of alkali metal silicate having a molar ratio of SiO₂/M₂O of from 0.5 to 0.75 (i.e., SiO₂/M₂O is from 1.0 to 1.5), an SiO₂ content of from 1 to 4 wt%, and containing at least 20% of potassium based on the gram atoms of all the alkaline metals contained therein as disclosed in JP-B-57-7427 (the term "JP-B" as used herein means an "examined Japanese patent publication") are preferably used. A development processing solution can contain various kinds of surfactants and organic solvents for the purpose of accelerating development property, dispersing development residues, and heightening the affinity of the image area of a printing plate with ink, if necessary. As the preferred surfactants, anionic, cationic, nonionic and ampholytic surfactants can be exemplified.

These surfactants may be used alone or two or more may be used in combination, preferably added to a development processing solution in an amount of from 0.001 to 10 wt%, more preferably from 0.01 to 5 wt%.

An organic solvent may be added to a development processing solution, if necessary. An organic solvent having a solubility in water of 10 wt% or less, preferably 5 wt% or less is preferably used, e.g., 1-phenylethanol, 2-phenylethanol, 3-phenyl-1-propanol, 4-phenyl-1-butanol, 4-phenyl-2-butanol, 2-phenyl-1-butanol, 2-phenoxyethanol, 2-benzyloxyethanol, o-methoxybenzyl alcohol, m-methoxybenzyl alcohol, p-methoxybenzyl alcohol, benzyl alcohol, cyclohexanol, 2-methylcyclohexanol, 3-methylcyclohexanol, 4-methylcyclohexanol, N-phenylethanolamine or N-phenyldiethanolamine can be exemplified as such an organic solvent. The content of an organic solvent is from 0.1 to 5 wt% based on the total weight of the solution. The use amount of an organic solvent intimately relates to the use amount of a surfactant. It is preferred to increase the amount of a surfactant as the amount of an organic solvent is increased. This is due to the fact that if the amount of a surfactant is small and the amount of an organic solvent is large, the organic solvent does not dissolve completely and good development property cannot be ensured.

A development processing solution may further contain an antiseptic, a coloring agent, a thickener, a defoaming agent and a water softener, if necessary. Examples of water softeners include, e.g., polyphosphoric acid, and sodium salt, potassium salt and ammonium salt thereof, aminopolycarboxylic acid such as ethylenediaminetetraacetic acid, diethylenetriaminepentaacetic acid, triethylenetetraminehexaacetic acid, hydroxyethylethylenediaminetriacetic acid, nitrilotriacetic acid, 1,2-diaminocyclohexanetetraacetic acid, and 1,3-diamino-2-propanoltetraacetic acid, and sodium salt, potassium salt and ammonium salt thereof, aminotri-(methylenephosphonic acid), ethylenediaminetetra(methylenephosphonic acid), diethylenetriaminepenta (methylenephosphonic acid), triethylenetetraminehexa (methylenephosphonic acid), hydroxyethylethylenediaminetri (methylenephosphonic acid), and 1-hydroxyethane-1,1-diphosphonic acid, and sodium salt, potassium salt and ammonium salt thereof.

The proper addition amount of these water softeners varies according to their chelating ability and the hardness and the amount of the hard water to be used but the general amount is preferably from 0.01 to 5 wt%, more preferably from 0.01 to 0.5 wt%, based on the development processing solution to be used. If the addition amount is less than this range, the desired object cannot be achieved, while when the amount is larger than this range, an image area gets an adverse influence such as decoloration.

A particularly preferred material having a photosensitive resin composition to which the present invention can be applied is a photosensitive material for lithographic printing, and a PS plate having a positive photosensitive resin composition is preferred above all.

As the positive photosensitive resin composition, those whose solubility in a development processing solution or swelling property varies before and after exposure can be used in the present invention, and they are often used in a PS plate. A preferred sensitizer is an o-quinonediazide compound. For example, in the case of a positive photosensitive resin composition containing an alkali-soluble resin and an o-quinonediazide compound, a compound having at least one o-quinonediazide group and whose solubility in an alkaline aqueous solution increases by irradiation with an active light is preferably used as the o-quinonediazide compound.

The compounds of various structures having this kind of quinonediazide group are known and described in detail, e.g., in J. Kosar, Light-Sensitive Systems, pp. 336 to 352, John Wiley & Sons, Inc. (1965). Various kinds of hydroxyl compounds, o-benzoquinonediazide and o-naphthoquinonediazide sulfonates are preferred as the positive photosensitive resin composition.

As the positive photosensitive resin composition other than the above o-quinonediazides, compounds which are water-insoluble but alkali-soluble and the alkali-soluble group of which is protected with an acid-decomposable group and used in combination with a light-acid generating agent can be used as the chemically amplified photosensitive resin compositions. Chemically amplified photosensitive resin compositions are used as the materials for lithographic printing, integrated circuits and photoresists for other high definition microfabrication, and the development is performed by making use of the alkali solubility of an exposed area.

Well-known light-acid generating agents can be used as the light-acid generating agent in chemically amplified photosensitive resin compositions. As the light-acid generating agent, compounds such as a photo-initiator of photo-cationic polymerization, a photo-initiator of photo-radical polymerization, a photo-decoloring agent of dyes, a discoloring agent, and well-known compounds which generate acid by the irradiation with light for use in microresists, and mixtures of these compounds can be used arbitrarily.

Further, compounds which are water-insoluble but alkali-soluble and the alkali-soluble group of which is protected with an acid-decomposable group used in combination with a light-acid generating agent in chemically amplified photosensitive resin compositions are the compounds having a -C-O-C- or -C-O-Si- bond, and the following examples can be exemplified.
(a) A compound containing at least one orthocarboxylate group and/or carboxylic acid amide acetal group, capable of having polymerizability, and the above group(s) can be the crosslinking component in the main chain or the substituent at the side chain,
(b) An oligomeric compound or a polymer compound containing a repeating acetal group and/or a ketal group in the main chain,
(c) A compound containing at least one enol ester group or N-acylaminocarbonate group,
(d) A cyclic acetal or a ketal of β-keto ester or β-ketoamide,
(e) A compound containing a silyl ether group,
(f) A compound containing a silyenol ether group,
(g) Monoacetal or monoketal in which an aldehyde or ketone component has a solubility of from 0.1 to 100 g/liter in a developer,
(h) A tertiary alcohol ether, and
(i) Carboxylate and carbonate of the alcohol of tertiary allylic position or benzylic position.

As the synthetic resins which are insoluble in water but soluble in an aqueous alkaline solution (hereinafter referred to as alkali-soluble resins), e.g., a phenol-formaldehyde resin, a cresol-formaldehyde resin, a phenol-cresol-formaldehyde co-condensation resin, a phenol-modified xylene resin, polyhydroxystyrene, polyhalide hydroxystyrene, an N-(4-hydroxyphenyl) methacrylamide copolymer, a hydroquinone monomethacrylate copolymer, the sulfonylimide polymers disclosed in JP-A-7-28244, and the polymers containing a carboxyl group disclosed in JP-A-7-36184 can be exemplified. In addition, a variety of alkali-soluble high molecular weight compounds, such as the acrylate resins containing a phenolic hydroxyl group disclosed in JP-A-51-34711, the acrylate resins containing a sulfonamido group disclosed in JP-A-2-866, urethane resins, etc., can also be used. These alkali-soluble high molecular weight compounds have a weight average molecular weight of from 500 to 20,000 and a number average molecular weight of from 200 to 60,000. These alkali-soluble high molecular weight compounds may be used alone or two or more of them may be used in combination. They are used in addition amount of 80 wt% or less based on the total composition.

A material having a photopolymerizable photosensitive resin composition, which is one of the materials having a photosensitive resin composition for use in the present invention, will be described in the next place. A photopolymerizable photosensitive resin composition for use in the present invention is a compound containing an addition polymerizable ethylenically double bond as the main component, a photopolymerization initiator, etc., and a compound such as a thermal polymerization inhibitor, etc., may be added, if necessary.

A compound containing an addition polymerizable ethylenically double bond can be arbitrarily selected from the compounds having at least one, preferably two or more, terminally ethylenically unsaturated bond, e.g., those assuming the chemical forms of a monomer and a prepolymer, i.e., a dimer, a trimer and an oligomer, or mixtures of them, and copolymers of them.

As examples of a monomer and the copolymers of them, esters of unsaturated carboxylic acid (e.g., acrylic acid, methacrylic acid, itaconic acid, crotonic acid, isocrotonic acid, maleic acid, etc.) and aliphatic polyhydric alcohol, and amides of unsaturated carboxylic acid and an aliphatic polyvalent amine compound can be exemplified.

As the photopolymerization initiators contained in the photopolymerizable photosensitive resin compositions for use in the present invention, various photopolymerization initiators well-known by patents and literature can be arbitrarily used alone or in combination of two or more according to the wavelengths of the light sources to be used. For example, when a wavelength of 400 nm or so is used as a light source, benzyl, benzoin ether, Michler's ketone, anthraquinone, thioxanthone, acridine, phenazine, benzophenone, etc., are widely used.

The present invention can be used in a positive PS plate using the above-described quinonediazide or a compound having an alkali-soluble group protected with an acid-decomposable group, and a negative PS plate using a photopolymerization system. Besides the above, the present invention can also be applied to the following materials of a lithographic printing plate, printed wiring and a resist for forming an integrated circuit.
(1) A material for a negative lithographic printing plate using a diazo resin,
(2) A material for a negative lithographic printing plate using a photo-crosslinking resin,
(3) A material for a negative direct imaging lithographic printing plate by laser containing an alkali-soluble binder, an acid-generating agent, or an acid (thermal) crosslinking compound, and
(4) A material for a positive direct imaging lithographic printing plate by laser containing an alkali-soluble binder, and a substance which is heat-decomposable but substantially reduces the solubility of the alkali-soluble binder when it is in a state not decomposed.

The coating amount (a solid content) of the image-forming layer obtained after coating and drying differs according to use purpose, but the coating amount in a generally used lithographic printing plate precursor is preferably from 0.5 to 5.0 g/m², more preferably from 0.5 to 1.5 g/m². The layer thickness is generally from 0.01 to 100 µm, preferably from 0.1 to 10 µm, and more preferably from 0.3 to 1 µm.

### PREFERRED EMBODIMENTS OF THE PRESENT INVENTION

The present invention will be described in greater detail below with reference to the accompanying drawings, but the invention should not be construed as being limited thereto.

### Embodiment 1-1

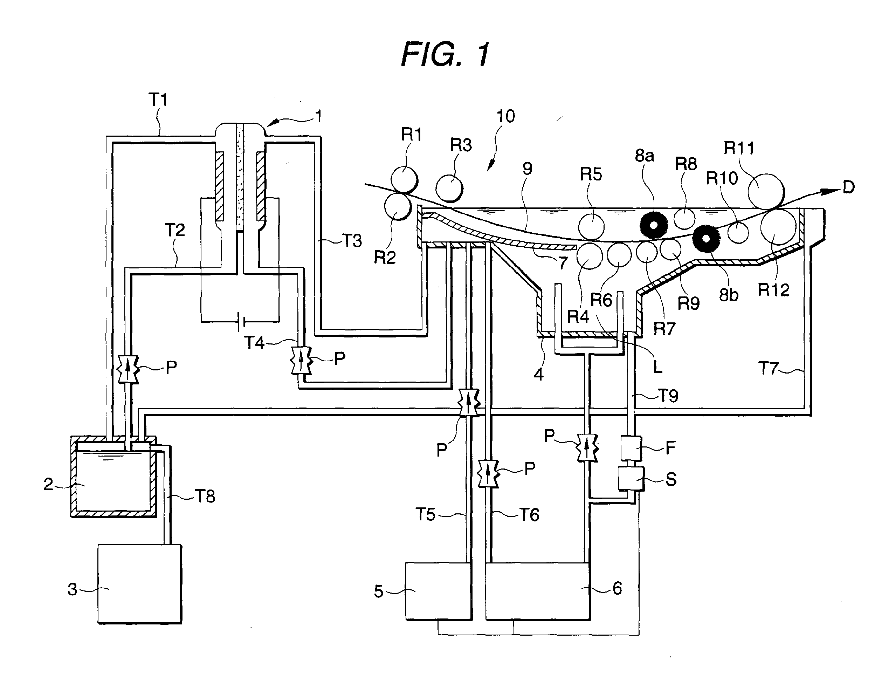

Development processing apparatus 10 shown in Fig. 1 is an apparatus for developing a PS plate for forming a lithographic printing plate according to Embodiment 1-1 of the present invention. Development processing apparatus 10 is equipped with developing bath 4, and developing bath 4 is filled with development processing solution L. PS plate 9 after exposure is sent in developing bath 4. PS plate 9 sent in is transported in developing bath 4 by means of guide 7 and rollers R1 to R12, and development processed by being slid by means of brushes 8a and 8b with passing through generally the path shown by arrow D. Thereafter, PS plate 9 is sent in the manufacturing step of the next stage. Piping T9 is installed at the bottom near the central part of developing bath 4, and the discharge from the spray provided at the outlet of the piping forked into two branches assists the stirring of development processing solution L. More stable development can be performed by this stirring. Filter F and electric conductivity sensor S are provided at intermediate portions of piping T9 to filtrate the impurities in development processing solution L and measure the electric conductivity of development processing solution L respectively.

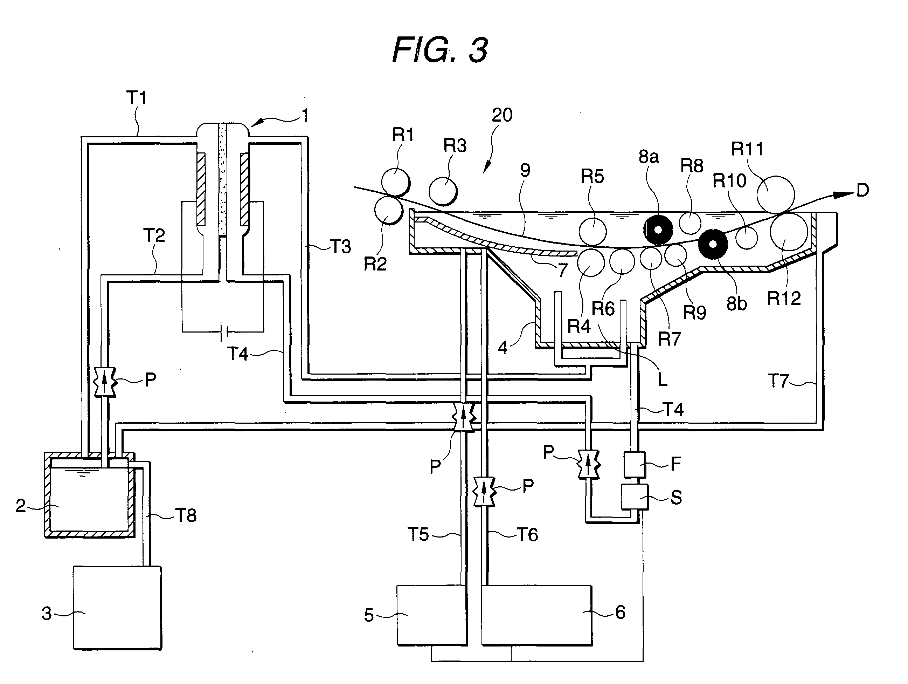

The pH value of development processing solution L becomes smaller and the developing performance gradually reduces due to the processing fatigue with the development processing of PS plate 9 and the aging fatigue caused by the contact with air. A developing replenisher is supplied to developing bath 4 for recovering the developing performance. The replenishing rate is determined by the electric conductivity of development processing solution L measured by electric conductivity sensor S. Into developing bath 4 are introduced a developing replenisher from developing replenisher tank 5 through piping T5 and, at the same time, a dilution water from dilution water tank 6 through piping T6. Pumps P are provided at an intermediate portion of each of piping T5 and piping T6, and a developing replenisher and a dilution water are supplied to developing bath 4 via pumps P. In Fig. 1 (and also in Fig. 3 to Fig. 5), the arrow in pump P shows the direction of the solutions flowing in the pump. Further, pump P in this embodiment is a bellows pump but other pumps, e.g., a magnet pump, may be used. In this embodiment, the developing replenisher and the dilution water introduced into developing bath 4 are mixed in developing bath 4 to make development processing solution L, but development processing solution L may be introduced into developing bath 4 after being mixed.

Development processing solution L overflown from developing bath 4 by the replenishment of a replenisher is introduced into intermediate waste solution tank 2 through piping T7. The solution passed through piping T7 is called an intermediate waste solution for convenience sake. On the one hand of the above overflow, a part of development processing solution L is introduced into electrolytic cell 1 through piping T4 on the other hand. The solution passed through piping T4 is called a developing working solution for convenience sake. Piping T8 besides T1 and T2 is connected to intermediate waste solution tank 2. Piping T8 is connected to waste solution tank 3, and when the intermediate waste solution in intermediate waste solution tank 2 exceeds a definite amount, the intermediate waste solution is introduced into waste solution tank 3 through piping T8.

Although the developing performance of the above-described intermediate waste solution and developing working solution is reduced due to processing fatigue and aging fatigue, but they are fundamentally solutions still having developing performance (containing alkali component). According to the present invention, these solutions are introduced into electrolytic cell 1 to be subjected to electrolysis properly, thus the negative electric charge (electron) in the intermediate waste solution is transferred into the developing working solution with reducing the hydroxide ions in the intermediate waste solution and increasing the hydroxide ions in the developing working solution, to thereby lower the pH value of the intermediate waste solution and increase the pH value of the developing working solution. That is, the alkalinization of the developing working solution introduced into electrolytic cell 1 progresses and, similarly, the neutralization of the intermediate waste solution progresses. Accordingly, the developing performance of the developing working solution is recovered by electrolysis. The mechanism of the electrolysis is described below together with explanations of electrolytic cell 1.

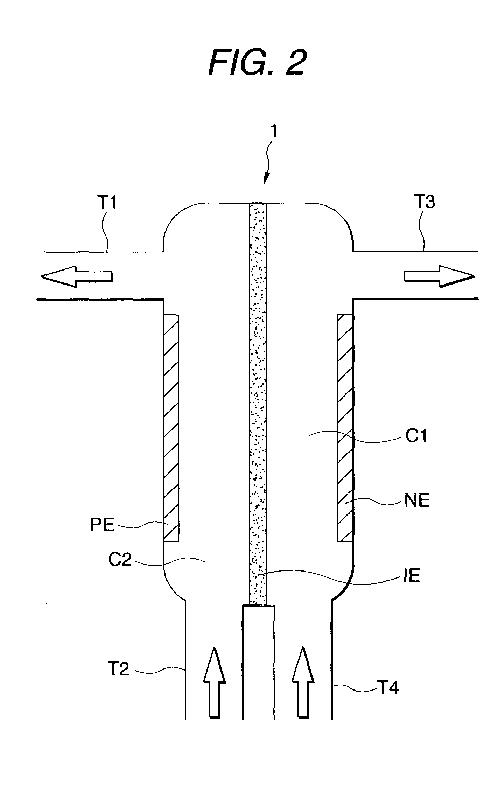

Fig. 2 is an enlarged diagram showing electrolytic cell 1. Electrolytic cell 1 comprises positive electrode chamber C2 communicating with intermediate waste solution tank 2 via pipings T1 and T2 and negative electrode chamber C1 communicating with developing bath 4 via pipings T3 and T4. Negative electrode chamber C1 and positive electrode chamber C2 are partitioned by ion exchange membrane IE. Electrolytic cell 1 is further equipped with negative electrode NE arranged on the inner surface of the outside wall of negative electrode chamber C1 and positive electrode PE arranged on the inner surface of the outside wall of positive electrode chamber 2. Direct current voltage is impressed between positive electrode PE and negative electrode NE. An intermediate waste solution is introduced from piping T2 and a developing working solution is introduced from piping T4.

When an intermediate waste solution and a developing working solution are introduced into electrolytic cell 1, the developing working solution is brought into contact with negative electrode NE and, at the same time, the intermediate waste solution is brought into contact with positive electrode PE. At this time, if an electric current is applied to positive electrode PE and negative electrode NE, cations are discharged at negative electrode NE and react with water, as a result, an alkaline substance and hydrogen are generated. Hydroxide ions are discharged at positive electrode PE, as a result, water and oxygen are generated. The pH value of the developing working solution in negative electrode chamber C1 becomes large and the pH value of the intermediate waste solution in positive electrode chamber C2 becomes small by these reactions. Since negative electrode chamber C1 and positive electrode chamber C2 are isolated by ion exchange membrane IE, ion exchange via ion exchange membrane IE is limited.

The pH value of the developing working solution becomes large by electrolysis, thus the developing performance is recovered. The developing working solution is again introduced into developing bath 4 via piping T3 and the intermediate waste solution is again introduced into intermediate waste solution tank 2 via piping T1.

As described above, the developing working solution circulates a first route from developing bath 4 through piping T4, electrolytic cell 1, piping T3, and again to developing bath 4. On the other hand, the intermediate waste solution circulates a second route from intermediate waste solution tank 2 through piping T2, electrolytic cell 1, piping T1, and again to intermediate waste solution tank 2. The circulations are always done while development processing apparatus 10 is operated. The alkali component in developing bath 4 becomes difficult to reduce as the developing working solution is subjected to electrolysis treatment with circulating between developing bath 4 and electrolytic cell 1. Since the replenishing rate of a developing replenisher increases as the alkali component in developing bath 4 becomes more liable to reduce, the replenishing rate of a developing replenisher can be relatively reduced by carrying out the present invention. This means a reduction of the overflow from developing bath 4, which results in a reduction of an intermediate waste solution, furthermore, a reduction of a final waste solution.

The functions of circulating a development processing solution and an intermediate waste solution through the electrolytic cell are as follows. First, since the solutions are always circulating, the flowing in electrolytic cell 1 becomes good, and hydrogen and oxygen bubbles generated by electrolysis flow without stagnating on the electrodes. Secondly, since also the solutions are always circulating, the flowing in electrolytic cell 1 becomes good, and electrodeposition and precipitation of the composition in a photosensitive layer on the electrodes are difficult to occur. The increase of the interelectrode resistance can be inhibited by these functions. Accordingly, good electrolysis can be performed continuously.

### Embodiment 1-2

Fig. 3 shows Embodiment 1-2 of the present invention. In this embodiment, the action of piping T9 in Embodiment 1-1 is performed by the circulation from piping T4 to piping T3. Piping T4 communicates with the bottom near the central part of developing bath 4 and negative electrode chamber C1 of electrolytic cell 1, and filter F and electric conductivity sensor S are provided at intermediate portions of piping T4. Further, piping T3 communicating with negative electrode chamber C1 of electrolytic cell 1 and developing bath 4 assists the stirring of development processing solution L by the opening of the outlet of the piping forked into two branches. More stable development can be performed by this stirring. Accordingly, piping T9 in the embodiment shown in Fig. 1 can be omitted and the structure of the apparatus can be simplified.

### Embodiment 1-3

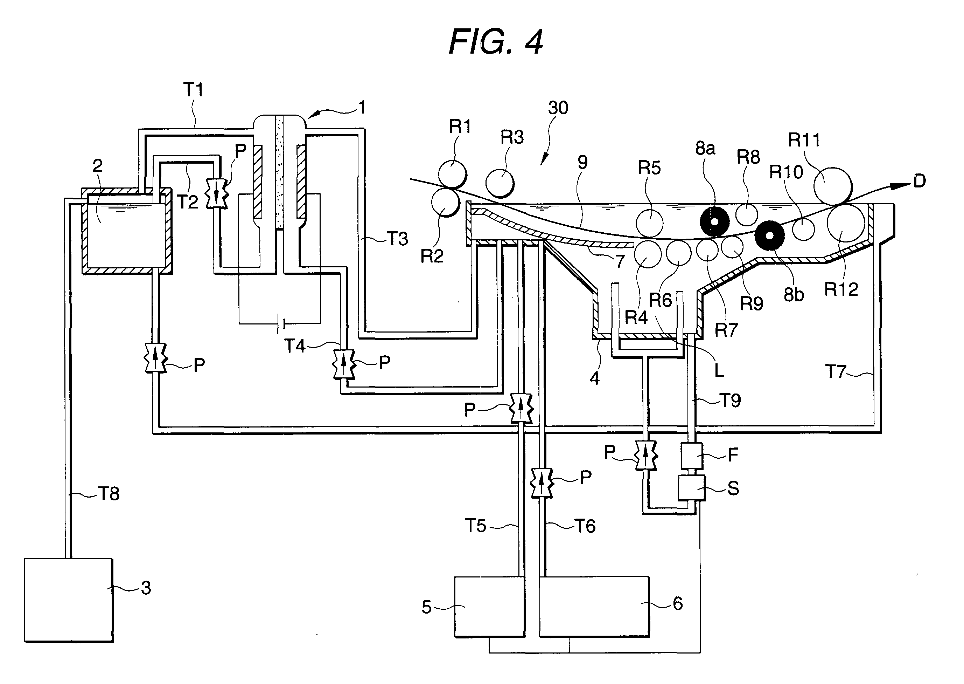

Fig. 4 shows Embodiment 1-3 of the present invention. The difference between Embodiment 1-1 and Embodiment 1-3 resides in heights of setting up of intermediate waste solution tank 2 and piping T8. In this embodiment, the places of installation of intermediate waste solution tank 2 and piping T8 are set so that the liquid level of the intermediate waste solution in intermediate waste solution tank 2 becomes equal to the liquid level of the development processing solution in a developing bath, and the overflow of the intermediate waste solution in intermediate waste solution tank 2 flows into piping T8. By this arrangement, the solution in electrolytic cell 1 can be prevented from flowing into intermediate waste solution tank 2 or developing bath 4 one-sidedly even if ion exchange membrane IE should be broken, and since the hydrostatic pressures between intermediate waste solution tank 2 and developing bath 4 are equal during stoppage of the apparatus (during stoppage of pump P), the fluctuation of the liquid level can be prevented.

### Embodiment 1-4

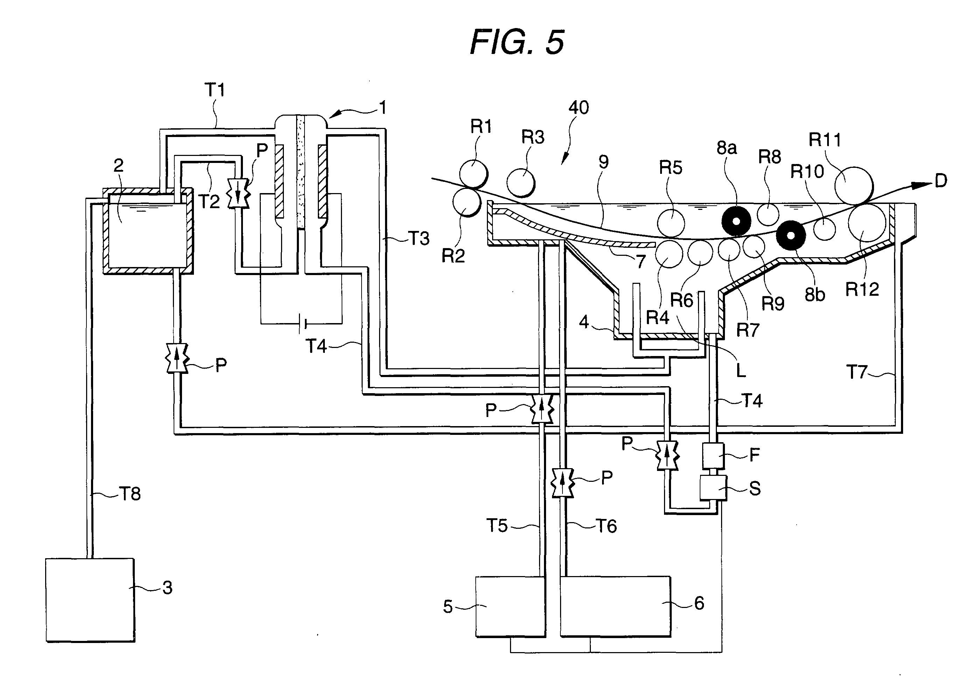

Fig. 5 shows Embodiment 1-4 of the present invention. This is the combination of Embodiments 1-2 and 1-3, and this embodiment has preferable functions of both embodiments. Piping T4 communicates with the bottom near the central part of developing bath 4 and negative electrode chamber C1 of electrolytic cell 1, and filter F and electric conductivity sensor S are provided at intermediate portions of piping T4. Further, piping T3 communicating with negative electrode chamber C1 of electrolytic cell 1 and developing bath 4 assists the stirring of development processing solution L by the discharge from the spray provided at the outlet of the piping forked into two branches. More stable development can be performed by this stirring. Accordingly, piping T9 in the embodiment shown in Fig. 1 can be omitted and the structure of the apparatus can be simplified. Further, the places of installation of intermediate waste solution tank 2 and piping T8 are set so that the liquid level of the intermediate waste solution in intermediate waste solution tank 2 becomes equal to the liquid level of the development processing solution in a developing bath, and the solution in electrolytic cell 1 can be prevented from flowing into intermediate waste solution tank 2 or developing bath 4 one-sidedly even if ion exchange membrane IE should be broken. Since the hydrostatic pressures between intermediate waste solution tank 2 and developing bath 4 are equal during stoppage of the apparatus (during stoppage of pump P), the fluctuation of the liquid level can be prevented.

As explained above, the development processing apparatus according to the first aspect of the present invention comprises: an intermediate waste solution tank to which the overflown waste solution from the developing bath is introduced; an electrolytic cell for electrolyzing the developing working solution introduced from the developing bath and the overflown waste solution introduced from the intermediate waste solution tank; and circulating mechanism comprising a first route for circulating the developing working solution between the negative electrode side of the electrolytic cell and the developing bath, and a second route for circulating the overflown waste solution between the positive electrode side of the electrolytic cell and the intermediate waste solution tank. Due to the above constitution, the amounts of a developing replenisher and a waste solution can be reduced, the electrodeposition of the components of a photosensitive layer on the electrodes can be inhibited due to the circulation of the solution, and bubbles generated by electrolysis can flow without stagnating, as a result, good electrolysis can be continued in an electrolytic cell. Therefore, the amount of a waste solution can be reduced with maintaining developing performance in the developing bath.

### Embodiment 2-1

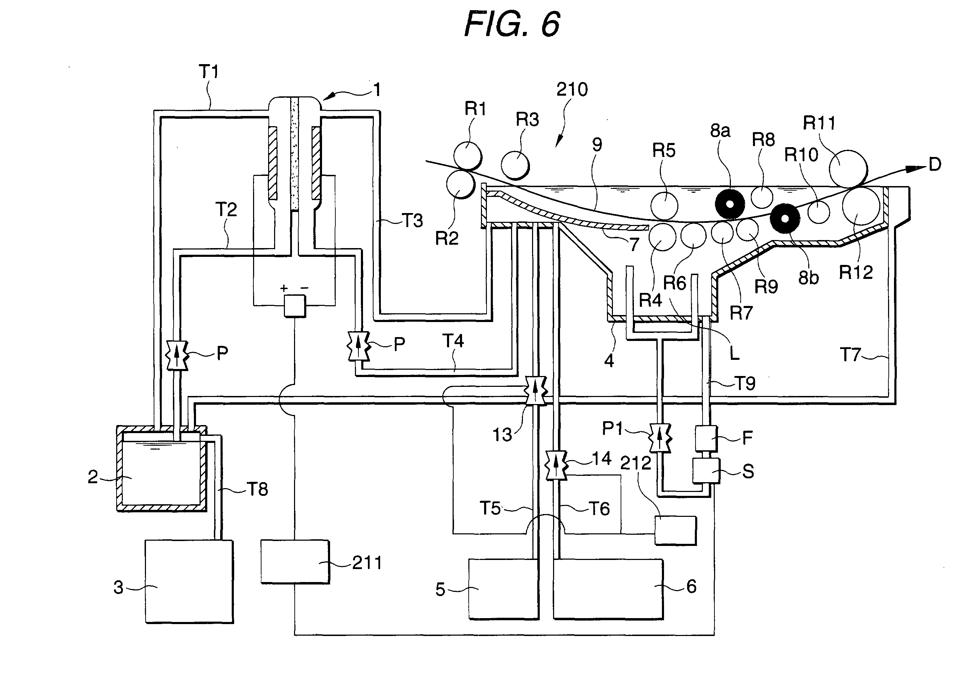

Development processing apparatus 210 shown in Fig. 6, which is Embodiment 2-1 of the present invention, is an apparatus for developing a PS plate for forming a lithographic printing plate. In this embodiment, conductance sensor S corresponds to a detector for detecting the development activity of the development processing solution.

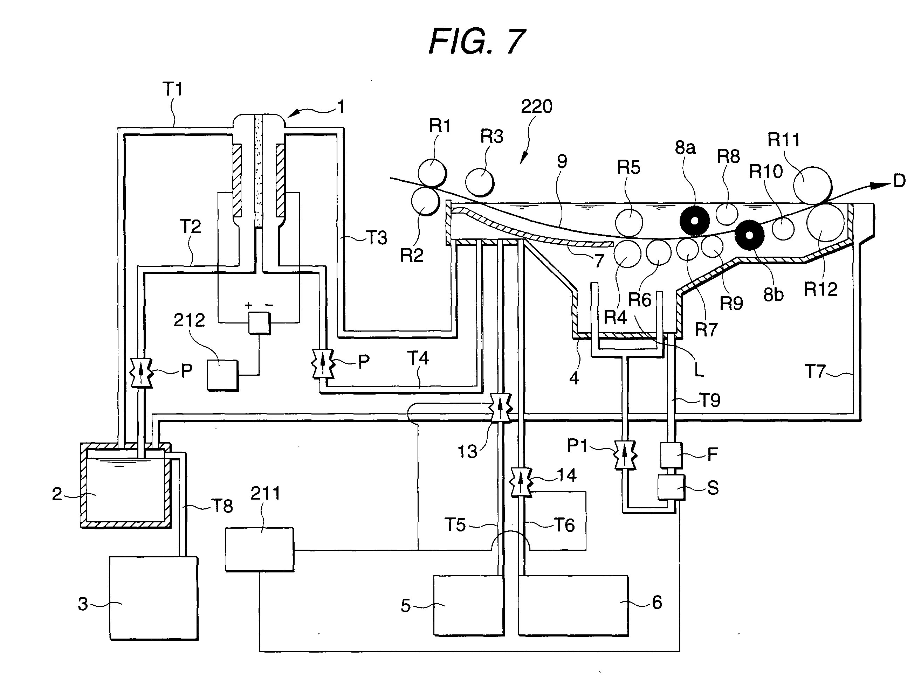

The pH value of development processing solution L becomes smaller and the developing performance gradually reduces due to the processing fatigue with the development processing of PS plate 9 and the aging fatigue caused by the contact with air. For recovering the developing performance, a replenishing member is provided for replenishing a developing replenisher to developing bath 4. Into developing bath 4 are introduced a developing replenisher from developing replenisher tank 5 through piping T5 and, at the same time, a dilution water from dilution water tank 6 through piping T6. However, the amount of the developing replenisher to be replenished may be smaller than the amount conventionally replenished for the reason described below. Pumps 13 and 14 are provided at an intermediate portion of each of piping T5 and piping T6, and these pumps function as the above-described replenishing members. In Fig. 6 (and also in Fig. 7), the arrows in pumps 13, 14 and other pumps P show the direction of the solutions flowing in these pumps.

Since pumps 13 and 14 are connected to controller 212, the replenishment of a developing replenisher by means of pumps 13 and 14 is controlled by the instruction periodically given by controller 212 according to at least one of the cumulative processing area of PS plate 9, the cumulative operating time of development processing apparatus 210, and the cumulative stopping time of development processing apparatus 210.

Further, pumps 13, 14 and P in this embodiment are bellows pumps and pump p1 is a magnet pump, but other pumps may be used. In this embodiment, the developing replenisher and the dilution water introduced into developing bath 4 are mixed in developing bath 4 to make development processing solution L, but development processing solution L may be introduced into developing bath 4 after being mixed.

Electrolysis is performed in electrolytic cell 1 in the same manner as in Embodiment 1-1, but this electrolysis is controlled by controller 211 connected to electric conductivity sensor S according to the value detected by electric conductivity sensor S. For instance, when the detected value inputted in controller 211 is smaller than the threshold value prescribed in controller 211 in advance, an electric current is applied to electrolytic cell 1 to perform electrolysis, and when the detected value is larger than the threshold value, electrolysis is not performed. Direct current voltage is impressed between positive electrode PE and negative electrode NE based on the instruction from controller 211.

The development processing solution is replenished according to at least one of the cumulative processing area of PS plate 9, the cumulative operating time of development processing apparatus 210, and the cumulative stopping time of development processing apparatus 210, and the replenishing rate of a developing replenisher is set smaller than the amount conventionally used, and the shortage of the alkali component in developing bath 4 is compensated for by electrolysis, hence the use amount of a developing replenisher can be reduced according to the present invention. This means a reduction of the overflow from developing bath 4, which results in a reduction of an intermediate waste solution, furthermore, a reduction of a final waste solution.

The functions of circulating a development processing solution and an intermediate waste solution through electrolytic cell 1 are as follows. First, since the solutions are always circulating, the flowing in electrolytic cell 1 becomes good, and hydrogen and oxygen bubbles generated by electrolysis flow without stagnating on the electrodes. Secondly, since also the solutions are always circulating, the flowing in electrolytic cell 1 becomes good, and precipitation of the composition in a photosensitive layer on the electrodes is difficult to occur. The increase of the interelectrode resistance can be inhibited by these functions. Accordingly, good electrolysis can be performed continuously.

### Embodiment 2-2

Development processing apparatus 220 shown in Fig. 7 is Embodiment 2-2 of the present invention, which is an apparatus of developing a PS plate for forming a printing plate. The differences between this embodiment and Embodiment 2-1 are that pumps 13 and 14 (replenishing members) are controlled by controller 212 and electrolytic cell 1 by controller 211. Other points are almost the same with those in Embodiment 2-1.

The pH value of development processing solution L becomes smaller and the developing performance gradually reduces due to the processing fatigue with the development processing of PS plate 9 and the aging fatigue caused by the contact with air. Accordingly, a developing replenisher is replenished to developing bath 4. The replenishment is controlled by controller 211 connected to electric conductivity sensor S according to the value detected by electric conductivity sensor S. For instance, when the detected value inputted in controller 211 is smaller than the threshold value prescribed in controller 211 in advance, replenishment of a developing replenisher is performed by means of driving pumps 13 and 14 provided at pipings T5 and T6 of undiluted developing replenisher tank 5 and dilution water tank 6, respectively, and when the detected value is larger than the threshold value, replenishment is not performed. Into developing bath 4 are introduced a developing replenisher from developing replenisher tank 5 through piping T5 and, at the same time, a dilution water from dilution water tank 6 through piping T6.

Electrolysis is performed in electrolytic cell 1 in the same manner as in Embodiment 2-1 and this electrolysis is controlled by controller 212 connected to electrolytic cell 1. Therefore, the electrolysis is controlled by the application of an electric current according to at least one of the cumulative processing area of PS plate 9, the cumulative operating time of development processing apparatus 220, and the cumulative stopping time of development processing apparatus 220.

The alkali component in developing bath 4 becomes difficult to reduce as the developing working solution is properly subjected to electrolysis treatment with circulating between developing bath 4 and electrolytic cell 1. Since the replenishing rate of a developing replenisher increases as the alkali component in developing bath 4 becomes more liable to reduce, the replenishing rate of a developing replenisher can be relatively reduced by carrying out the present invention. This means a reduction of the overflow from developing bath 4, which results in a reduction of an intermediate waste solution, furthermore, a reduction of a final waste solution.

As explained above, the development processing apparatus according to the second aspect of the present invention comprises: a replenishing member to replenish a developing replenisher to a developing bath according to at least one of the cumulative processing area of a photosensitive material, the cumulative operating time of the development processing apparatus, and the cumulative stopping time of the development processing apparatus; a detector to detect the development activity of the development processing solution in the developing bath; and an electrolytic cell for electrolyzing the developing working solution introduced from the developing bath, wherein the electrolytic cell is partitioned by a bulkhead between the negative electrode and the positive electrode, and contains circulating mechanism for circulating the developing working solution between the negative electrode side of the electrolytic cell and the developing bath, and is connected to a controller to control the application of an electric current to the positive electrode and the negative electrode according to the development activity of the development processing solution detected by the detector. Accordingly, the amount of the developing replenisher replenished according to at least one of the cumulative processing area of the photosensitive material, the cumulative operating time of the development processing apparatus, and the cumulative stopping time of the development processing apparatus can be set smaller than the amount conventionally used, and the shortage of an alkali component is compensated for by properly electrolyzing the overflown developing waste solution and the developing working solution in the electrolytic cell, and the developing working solution is then returned to the developing bath. Thus, the final waste solution can be reduced. Since the solutions are always circulating in the electrolytic cell, binders, etc., can be prevented from electrodepositing and precipitating on the electrodes, bubbles can be prevented from stagnating'on the electrodes, and the interelectrode resistance can be prevented from increasing. As a result, good electrolysis can be continued without consuming extra electric power.

Further, the development processing apparatus according to another embodiment of the second aspect of the present invention comprises: a replenishing member to replenish a developing replenisher to the developing bath; a detector to detect the development activity of the development processing solution in the developing bath; and an electrolytic cell for electrolyzing the developing working solution introduced from the developing bath, wherein the electrolytic cell is partitioned by a bulkhead between the negative electrode and the positive electrode, contains a circulating mechanism for circulating the developing working solution between the negative electrode side of the electrolytic cell and the developing bath, and is connected to a controller to control the application of an electric current to the positive electrode and the negative electrode according to the development activity of the development processing solution detected by the detector, and further, the replenishing member is connected to a controller to control the replenishment to the developing bath according to the development activity of the development processing solution detected by the detector. Accordingly, development processing can be performed with properly replenishing a smaller amount of a developing replenisher than the amount conventionally used by properly electrolyzing the overflown developing waste solution and the developing working solution in the electrolytic cell, and returning the developing working solution to the developing bath. Thus, the final waste solution can be reduced. Since the solutions are always circulating in the electrolytic cell, binders, etc., can be prevented from electrodepositing and precipitating on the electrodes, bubbles can be prevented from stagnating on the electrodes, and the interelectrode resistance can be prevented from increasing. As a result, good electrolysis can be continued without consuming extra electric power.

### Embodiment 3-1

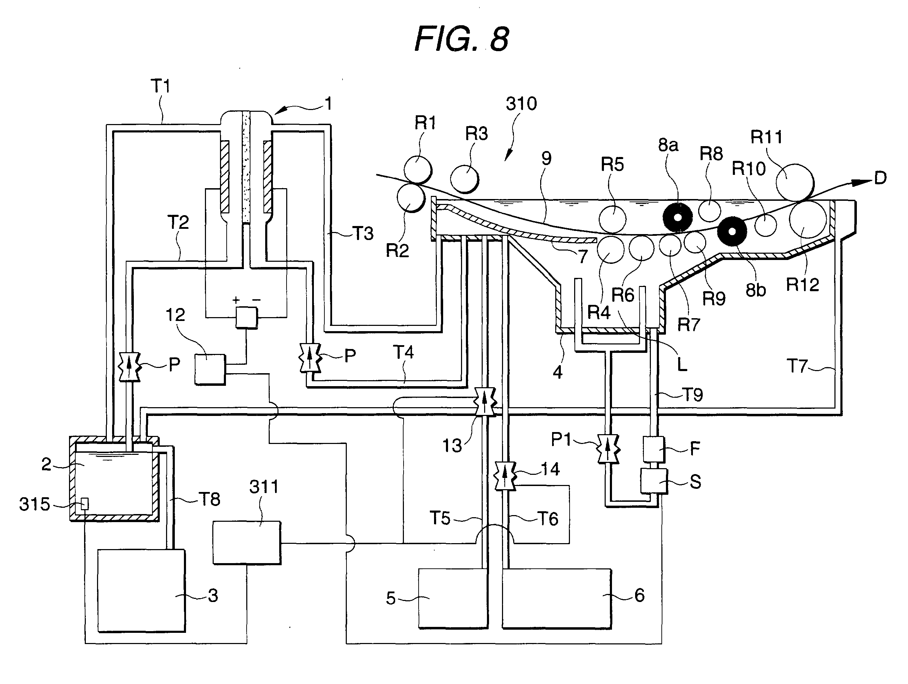

Development processing apparatus 310 shown in Fig. 8, which is an apparatus for carrying out the developing method as described in the above item (3-1), is an apparatus for developing a PS plate for forming a lithographic printing plate. Filter F and first sensor S are provided at intermediate portions of piping T9 to filtrate the impurities in development processing solution L and measure the electric conductivity of development processing solution L respectively.

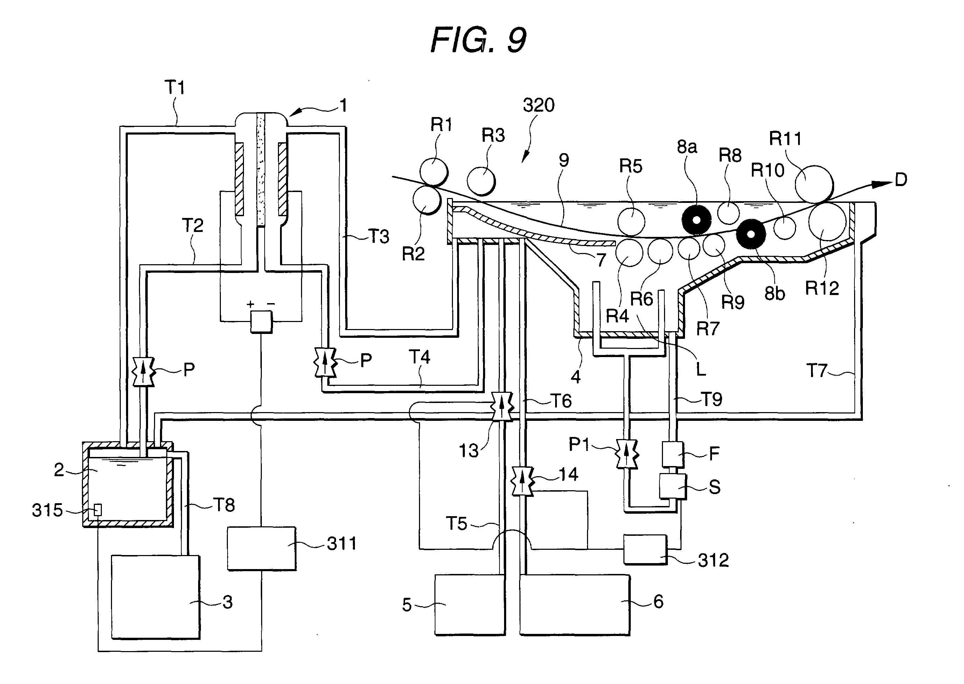

The pH value of development processing solution L becomes smaller and the developing performance gradually reduces due to the processing fatigue with the development processing of PS plate 9 and the aging fatigue caused by the contact with air. For recovering the developing performance, a replenishing member is provided for replenishing a developing replenisher to developing bath 4. Into developing bath 4 are introduced a developing replenisher from developing replenisher tank 5 through piping T5 and, at the same time, a dilution water from dilution water tank 6 through piping T6. However, the amount of the developing replenisher to be replenished may be smaller than the amount conventionally replenished for the reason described below. Pumps 13 and 14 are provided at an intermediate portion of each of piping T5 and piping T6, and these pumps function as the above-described replenishing members. In Fig. 8 (and also in Fig. 9), the arrows in pumps 13, 14 and P and other pumps P show the direction of the solutions flowing in these pumps.

Since pumps 13 and 14 are connected to controller 311, the replenishment of a developing replenisher by means of pumps 13 and 14 is controlled by the instruction periodically given by controller 311 according to at least one of the cumulative processing area of PS plate 9, the cumulative operating time of development processing apparatus 310, and the cumulative stopping time of development processing apparatus 310.

Further, pumps 13, 14 and P in this embodiment are bellows pumps and pump p1 is a magnet pump, but other pumps may be used. In this embodiment, the developing replenisher and the dilution water introduced into developing bath 4 are mixed in developing bath 4 to make development processing solution L, but development processing solution L may be introduced into developing bath 4 after being mixed.

Electrolysis is performed in electrolytic cell 1 in the same manner as in Embodiment 2-1. Direct current voltage is impressed between positive electrode PE and negative electrode NE based on the instruction from controller 312. The electric conductivity detected by first sensor 1 is inputted in controller 312, and the application of an electric current to electrolytic cell 1 is controlled according to the electric conductivity. For example, when the inputted electric conductivity is less than the proper electric conductivity, application of an electric current is performed. An intermediate waste solution is introduced from piping T2 and a developing working solution is introduced from piping T4.

The development processing solution is replenished according to at least one of the cumulative processing area of PS plate 9, the cumulative operating time of development processing apparatus 310, and the cumulative stopping time of development processing apparatus 310, and the replenishing rate of a developing replenisher is set smaller than the amount conventionally used, and the shortage of the alkali component in developing bath 4 is compensated for by electrolysis, hence the use amount of a developing replenisher can be relatively reduced according to the present invention. This means a reduction of the overflow from developing bath 4, which results in a reduction of an intermediate waste solution, furthermore, a reduction of a final waste solution.

The functions of circulating a development processing solution and an intermediate waste solution through electrolytic cell 1 are as follows. First, since the solutions are always circulating, the flowing in electrolytic cell 1 becomes good, and hydrogen and oxygen bubbles generated by electrolysis flow without stagnating on electrodes PE and NE. Secondly, since also the solutions are always circulating, the flowing in electrolytic cell 1 becomes good, and electrodeposition and precipitation of the composition in a photosensitive layer on electrodes PE and NE is difficult to occur. The increase of the interelectrode resistance can be inhibited by these functions. Accordingly, good electrolysis can be performed continuously.

In addition to the above behaviors, development processing apparatus 310 detects the development activity of the intermediate waste solution in intermediate waste solution tank 2 by second sensor 315 and adjusts the replenishing rate of the developing replenisher to developing bath 4 according to the development activity detected. In this embodiment, second sensor 315 is a pH sensor but second sensor 315 may be, e.g., an electric conductivity sensor. In such a case, another means to estimate a pH value from the detected electric conductivity is provided.

The detected and estimated pH value (this value is called a decision value) is inputted in controller 311, and controller 311 controls the replenishing rate of the developing replenisher according to at least one of the cumulative processing area of PS plate 9, the cumulative operating time of development processing apparatus 310, and the cumulative stopping time of development processing apparatus 310 based on the decision value. When the decision value is more than the allowable ceiling value, controller 311 actuates pumps 13 and 14 to reduce the replenishing rate of the developing replenisher to be replenished to developing bath 4 to thereby reduce the overflown solution amount from developing bath 4. While when the decision value is lower than the allowable bottom value, controller 311 actuates pumps 13 and 14 to increase the replenishing rate of the developing replenisher to be replenished to developing bath 4 to thereby increase the overflown solution amount from developing bath 4. If the amount of the solution overflown and introduced into the intermediate waste solution tank 2 is decreased, the pH value in the intermediate waste solution tank 2 gradually decreases by the circulation inclusive of electrolysis and becomes lower than the allowable ceiling value, in contrast with this, if the amount of the overflown solution is increased, the pH value in intermediate waste solution tank 2 gradually increases and becomes higher than the allowable bottom value.

In this embodiment, the allowable ceiling value is the boundary value (pH = 12.5 as of December, 1999) at which the intermediate waste solution comes under special control industrial waste. Since the pH value of the final waste solution almost equals to the pH value of the intermediate waste solution, the final waste solution can be discarded without coming under special control industrial waste by prescribing such allowable ceiling value.

Furthermore, the allowable bottom value is generally such that the photosensitive layer component dissolved into the waste solution is not precipitated or deposited, and the electrolysis in electrolytic cell 1 can be performed well, in this embodiment it is a pH value of 12.2. If the pH value of the intermediate waste solution decreases too much, hydroxide ions in the intermediate waste solution tank become insufficient and good electrolysis cannot be performed, therefore, it is effective to set this allowable bottom value. In addition, the replenishing rate of a developing replenisher replenished in development processing apparatus 310 is preferably smaller than the amount conventionally used. By reducing the amount of a replenisher, the amount of an overflown waste solution can be reduced, as a result, the amount of a waste solution can be reduced. Since the development processing apparatus according to the present invention contrives to recover the developing performance of the development processing solution also by electrolysis, the recovering function of the developing performance cannot be reduced even when the replenishing rate of a developing replenisher is reduced.

### Embodiment 3-2

Development processing apparatus 320 shown in Fig. 9, which is an apparatus for carrying out the developing method as described in the above item (3-2), is an apparatus for developing a PS plate for forming a lithographic printing plate. The differences between this embodiment and Embodiment 3-1 are that controller 311 does not control the actuation of pumps 13 and 14 but controls the application amount of an electric current to electrolytic cell 1 and that controller 312 controls the actuation of pumps 13 and 14. Other points are almost the same with those in Embodiment 3-1.

In development processing apparatus 320, the application of an electric current to the positive electrode and the negative electrode in electrolytic cell 1 is performed by controller 311 according to at least one of the cumulative processing area of PS plate 9, the cumulative operating time of development processing apparatus 20, and the cumulative stopping time of development processing apparatus 20, by which the developing performance in developing bath 4 is recovered. At the same time, the developing replenisher is replenished by the instruction from controller 312 sent according to the development activity in developing bath 4 detected by first sensor S. Further, the development activity of the intermediate waste solution in intermediate waste solution tank 2 is detected by second sensor 15 for the intermediate waste solution, and the application of an electric current to the positive electrode and the negative electrode in electrolytic cell 1 is performed according to the development activity. When an electric current is impressed, electrolysis is performed in electrolytic cell 1. Since the developing working solution is brought into contact with the negative electrode, the concentration of the alkali component (i.e., a hydroxide ion) increases by the electrolysis and the developing performance is recovered. Since the intermediate waste solution is brought into contact with the positive electrode, the alkali component decreases by the electrolysis. That is, the pH value of intermediate waste solution can be decreased while increasing the pH value of the developing working solution. According to this mechanism, the intermediate waste solution in the intermediate waste solution tank 2 can be made harmless while recovering the developing performance of the developing working solution in developing bath 4 (i.e., development processing solution L). The final waste solution is a waste solution discharged from intermediate waste solution tank 2, hence decreasing the pH value of the intermediate waste solution almost equals to decreasing the pH value of the final waste solution.

In Embodiment 3-2, when the decision value is more than the allowable ceiling value, the application amount of an electric current to the positive electrode and the negative electrode is increased. The allowable ceiling value is, for example, the boundary value (pH = 12.5 as of December, 1999) at which the intermediate waste solution comes under special control industrial waste. Since the pH value of the final waste solution almost equals to the pH value of the intermediate waste solution, the final waste solution can be discarded without coming under special control industrial waste by prescribing such allowable ceiling value. Further, when the decision value is lower than the allowable bottom value, the application amount of an electric current to the positive electrode and the negative electrode is decreased. For example, the allowable bottom value is generally such that the photosensitive layer component dissolved into the waste solution is not precipitated or deposited, and the electrolysis in electrolytic cell 1 can be performed well, in this embodiment it is a pH value of 12.2. If the pH value of the intermediate waste solution decreases too much, hydroxide ions in the intermediate waste solution tank become insufficient and good electrolysis cannot be performed, therefore, it is effective to set this allowable bottom value.

In addition, the replenishing rate of the developing replenisher replenished in development processing apparatus 320 is preferably smaller than the amount conventionally used. By reducing the amount of a replenisher, the amount of an overflown waste solution can be reduced, as a result, the amount of a waste solution can be reduced. Since the development processing apparatus according to the present invention contrives to recover the developing performance of the development processing solution also by electrolysis, the recovering function of the developing performance cannot be reduced even when the replenishing rate of a developing replenisher is reduced.

The above-described allowable ceiling value and allowable bottom value may be de determined according to the decree.

According to the developing method as described in the above-described item (3-1) in the third aspect of the present invention, the amount of a waste solution can be reduced with maintaining the development activity of a development processing solution, wherein the development activity of the developing solution in a developing bath is maintained by electrolytic treatment of the developing solution in the negative electrode side of an electrolytic cell, and replenishing a developing replenisher to the developing solution in the developing bath, the development activity of the developing solution in the developing bath is detected and the electrolytic treatment is performed according to the value detected, and the replenishment of the developing replenisher is performed by corresponding to the processing area of the photosensitive material and the operating time of the development processing apparatus, and the correspondence is adjusted according to the physical properties of the developing waste solution introduced into the positive electrode side of the electrolytic cell.

According to the developing method as described in the above-described item (3-2) in the third aspect of the present invention, the amount of a waste solution can be reduced with maintaining the development activity of a development processing solution, wherein the development activity of the developing solution is maintained by electrolytic treatment of the developing solution in the negative electrode side of an electrolytic cell, and replenishing a developing replenisher to the developing solution in the developing bath, the development activity of the developing solution in the developing bath is detected and the replenishment of the developing replenisher is performed according to the value detected, and the electrolytic treatment is performed by corresponding to the processing area of the photosensitive material and the operating time of the development processing apparatus, and the correspondence is adjusted according to the physical properties of the developing waste solution introduced into the positive electrode side of the electrolytic cell.

While the invention has been described in detail and with reference to specific examples thereof, it will be apparent to one skilled in the art that various changes and modifications can be made therein without departing from the spirit and scope thereof.

## Claims

1. A development processing apparatus comprising:
a developing bath for developing an exposed photosensitive material having a photosensitive resin composition with a development processing solution;
an intermediate waste solution tank to which an overflown waste solution from said developing bath is introduced;
an electrolytic cell which electrolyzes a developing working solution introduced from said developing bath and said overflown waste solution introduced from said intermediate waste solution tank, said electrolytic cell comprising a negative electrode chamber having a negative electrode, a positive electrode chamber having a positive electrode and a bulkhead to divide said negative electrode chamber and said positive electrode chamber; and
a circulating mechanism comprising a first route for circulating said developing working solution between the negative electrode chamber of said electrolytic cell and the developing bath, and a second route for circulating said overflown waste solution between the positive electrode chamber of said electrolytic cell and the intermediate waste solution tank.

2. The development processing apparatus according to claim 1, wherein said intermediate waste solution tank has an overflow opening and said overflow opening is arranged so that a liquid level of the waste solution in said intermediate waste solution tank is located at the same height as a liquid level of the development processing solution in said developing bath.

3. A development processing apparatus comprising:
a developing bath for developing an exposed photosensitive material with a development processing solution;
a replenishing member which replenishes a developing replenisher to said developing bath according to at least one of: a cumulative processing area of said photosensitive material; a cumulative operating time of said development processing apparatus; and a cumulative stopping time of said development processing apparatus;
a detector which detects a development activity of the development processing solution in said developing bath;
an electrolytic cell which electrolyzes a developing working solution introduced from said developing bath, said electrolytic cell comprising a negative electrode chamber having a negative electrode, a positive electrode chamber having a positive electrode and a bulkhead to divide said negative electrode chamber and said positive electrode chamber;
a circulating mechanism for circulating said developing working solution between the negative electrode chamber of said electrolytic cell and the developing bath; and
a controller which is connected to said electrolytic cell so as to control application of an electric current to said positive and negative electrodes according to the development activity of the development processing solution detected by said detector.

4. A development processing apparatus comprising:
a developing bath for developing an exposed photosensitive material with a development processing solution;
a replenishing member which replenishes a developing replenisher to said developing bath;
a detector which detects a development activity of the development processing solution in said developing bath;
an electrolytic cell which electrolyzes a developing working solution introduced from said developing bath, said electrolytic cell comprising a negative electrode chamber having a negative electrode, a positive electrode chamber having a positive electrode and a bulkhead to divide said negative electrode chamber and said positive electrode chamber;
a circulating mechanism for circulating said developing working solution between the negative electrode chamber of said electrolytic cell and the developing bath;
a first controller which is connected to said electrolytic cell so as to control application of an electric current to said positive and negative electrodes according to at least one of: a cumulative processing area of said photosensitive material; a cumulative operating time of said development processing apparatus; and a cumulative stopping time of said development processing apparatus; and
a second controller which is connected to said replenishing member so as to control the replenishment to said developing bath according to the development activity of the development processing solution detected by said detector.

5. The development processing apparatus according to claim 3 or 4, wherein said detector detects, as the development activity, at least one of: an electric conductivity, a pH value, a specific gravity and an opacity of said development processing solution.

6. The development processing apparatus according to claim 3 or 4, which further comprises:
an intermediate waste solution tank to which an overflown waste solution from said developing bath is introduced; and
a circulating mechanism to introduce the intermediate waste solution in said intermediate waste solution tank into the positive electrode chamber of said electrolytic cell and again introduce the intermediate waste solution back into said intermediate waste solution tank.

7. A method for developing an exposed photosensitive material using a development processing apparatus comprising: a developing bath and an electrolytic cell comprising a negative electrode chamber and a positive electrode chamber, which developing method comprising:
maintaining a development activity of a developing solution,
wherein said maintaining of the development activity of the developing solution is carried out by electrolytic treatment of the developing solution in the negative electrode chamber of said electrolytic cell, and by replenishing a developing replenisher to the developing solution in said developing bath,
said electrolytic treatment being performed according to a development activity of the developing solution detected in said developing bath,
said replenishment of the developing replenisher being performed by corresponding to a processing area of said photosensitive material and an operating time of said development processing apparatus, wherein said correspondence is controlled according to a physical property of a developing waste solution introduced into the positive electrode chamber of said electrolytic cell.

8. A method for developing an exposed photosensitive material using a development processing apparatus comprising: a developing bath and an electrolytic cell comprising a negative electrode chamber and a positive electrode chamber, which developing method comprising:
maintaining a development activity of a developing solution,
wherein said maintaining of the development activity of the developing solution is carried out by electrolytic treatment of the developing solution in the negative electrode chamber of said electrolytic cell, and by replenishing a developing replenisher to the developing solution in said developing bath,
said replenishment of the developing replenisher being performed according to a development activity of the developing solution detected in said developing bath,
said electrolytic treatment being performed by corresponding to a processing area of said photosensitive material and an operating time of said development processing apparatus, wherein said correspondence is controlled according to a physical property of a developing waste solution introduced into the positive electrode chamber of said electrolytic cell.
